Europäisches Patentamt

European Patent Office

Office européen des brevets

(19)

(11) **EP 0 454 266 B1**

(12) **EUROPÄISCHE PATENTSCHRIFT**

(45) Veröffentlichungstag und Bekanntmachung des Hinweises auf die Patenterteilung:
**29.12.1997 Patentblatt 1997/52**

(51) Int Cl.6: **H04B 7/005**, H03J 7/02, H04B 1/10, H04B 1/16

(21) Anmeldenummer: **91200996.6**

(22) Anmeldetag: **25.04.1991**

(54) **Empfänger mit einer Anordnung zur Frequenzablagenschätzung**

Receiver comprising a circuit for estimating frequency offset

Récepteur comprenant un circuit pour estimer l'écart de fréquence

(84) Benannte Vertragsstaaten:
**DE DK FR GB IT**

(30) Priorität: **26.04.1990 DE 4013384**

(43) Veröffentlichungstag der Anmeldung:
**30.10.1991 Patentblatt 1991/44**

(73) Patentinhaber:
- **Philips Patentverwaltung GmbH**
  **22335 Hamburg (DE)**
  Benannte Vertragsstaaten:
  **DE**
- **Philips Electronics N.V.**
  **5621 BA Eindhoven (NL)**
  Benannte Vertragsstaaten:
  **DK FR GB IT**

(72) Erfinder: **Baier, Alfred, Dr.-Ing.**
**W-8501 Eckental (DE)**

(74) Vertreter: **Peuckert, Hermann, Dipl.-Ing. et al**
**Philips Patentverwaltung GmbH,**
**Röntgenstrasse 24**
**22335 Hamburg (DE)**

(56) Entgegenhaltungen:
**EP-A- 0 091 167**　　　**EP-A- 0 318 684**
**EP-A- 0 336 247**　　　**US-A- 4 058 713**

**Beschreibung**

Empfänger mit einer Anordnung zur Frequenzablagenschätzung.

Die Erfindung betrifft einen Empfänger für mittels einer Trägerfrequenz übertragene Signale mit einer Basisbandumsetzung und einer Anordnung zur Schätzung einer Frequenzablage.

Bei der Basisbandumsetzung von mittels einer Trägerfrequenz übertragenen Signalen werden Empfangssignale im Empfänger, gegebenenfalls nach Umsetzung in eine oder mehrere Zwischenfrequenzen, beispielsweise durch einen Quadraturmischer, in das Basisband umgesetzt. Durch Toleranzen und Drift der Sendefrequenz und der Mischfrequenzen im Empfänger kann es zu einer Frequenzablage im Basisbandsignal kommen, wodurch die Ubertragungsgüte beeinträchtigt wird. In Funkübertragungssystemen mit bewegten Sende- und/oder Empfangs einrichtungen ist durch Dopplereffekte darüber hinaus eine zeitlich relativ schnell schwankende Frequenzablage möglich, die sich der oben genannten, nur sehr langsam schwankenden, Frequenzablage additiv überlagert.

Um eine Beeinträchtigung der Übertragungsgüte durch eine Frequenzablage im Empfänger zu vermeiden bzw. gering zu halten ist es erforderlich, die Frequenzablage ständig zu schätzen und sie durch eine automatische Regelung der Mischfrequenzen möglichst klein zu halten oder sie durch andere analoge oder digitale Signalverarbeitungsmaßnahmen, beispielsweise eine Frequenzkorrektur im digitalisierten Basisbandsignal, zu kompensieren.

Aus dem Aufsatz von F. D. Natali, "AFC Tracking Algorithms", in IEEE Transactions on Communications, Vol. COM-32, August 1984, Seiten 935 bis 947 sind verschiedene Schaltungsanordnungen zur Frequenzablagenschätzung für Empfänger mit Basisbandumsetzung bekannt. Diese Frequenzablagenschätzer sind für zahlreiche digitale Modulationsverfahren geeignet, arbeiten aber generell nur dann zufriedenstellend, wenn der übertragungskanal verzerrungsfrei ist oder nur leichte Signalverzerrungen verursacht. Bei stark dispersiven Übertragungskanälen, wie sie sowohl bei der Funkübertragung als auch bei einer leitungsgebundenen Übertragung auftreten können, sind die mit diesen Frequenzablagenschätzern erreichten Ergebnisse nicht mehr zufriedenstellend.

Aufgabe der vorliegenden Erfindung ist es, eine Einrichtung zur Frequenzablagenschätzung für Empfänger der eingangs genannten Art anzugeben, die auch bei stark dispersiven Übertragungskanälen zufriedenstellend arbeitet.

Diese Aufgabe wird dadurch gelöst, daß das ins Basisband umgesetzte Signal einem Kanalschätzer zugeführt ist, der einen Kanalschätzvektor H als Schätzung der momentanen Kanalimpulsantworten in komplexer Basisbanddarstellung bildet, und daß der Frequenzablagenschätzer die zeitlichen Veränderungen dieser Kanalschätzvektoren auswertet.

Der Erfindung liegt die Erkenntnis zugrunde, daß eine Frequenzablage des Empfangssignals zu Phasenverdrehungen in der zeitvarianten Kanalimpulsantwort führt. Durch Analyse der zeitlichen Veränderungen der geschätzten Kanalimpulsantworten kann auf diese Weise auch bei stark dispersiven Übertragungskanälen die Frequenzablage zufriedenstellend geschätzt werden.

Bei zeitdiskreter Signaldarstellung bzw. Signalverarbeitung besteht ein vom Kanalschätzer für die Kanaleigenschaft ermittelter Kanalschätzvektor H aus K+1 komplexen Elementen $h_O, ... h_K$. Mit Schätzwerten der Kanalimpulsantwort lassen sich die zeitlichen Veränderungen der Kanalimpulsantworten in besonders einfacher Weise ermitteln und auswerten.

In der konkreten Ausführungsform des Frequenzablagenschätzers berechnet dieser aus zwei zu verschiedenen Zeitpunkten t(i), t(j) vorgenommenen Schätzungen der Kanalimpulsantworten H(i) und H(j) eine komplexe Größe C(i) nach der Beziehung

$$(1) \qquad C(i) = \sum_{k=0}^{K} h_k(i) \cdot h_k(j)^{\star} \quad ,$$

wobei der hochgestellte Stern zum Ausdruck bringt, daß die Elemente des betreffenden Kanalschätzvektors H(j) vor der Bildung der Maßzahl C(i) durch ihre konjugiert komplexen Werte ersetzt werden.

Während sich eine Frequenzabweichung in den Mischfrequenzen des Empfängers durch eine Frequenzablage in der Kanalimpulsantwort äußert, die für alle Elemente $h_k$ des Kanalschätzvektors H gleich ist, können die Elemente $h_k$ des Kanalschätzvektors H bei einer Funkübertragung über dispersive Übertragungskanäle unterschiedliche momentane Frequenzablagen aufweisen, die durch Dopplereffekte verursacht wurden. Durch die Summierung der komplexen Produktgrößen über alle Elemente $h_k$ der beiden betreffenden Kanalschätzvektoren wird in dieser Situation eine Mittelung aller Einzel-Frequenzablagen erzielt, wobei eine Gewichtung gemäß dem mittleren Energiebeitrag $|h_k(i)| \cdot |h_k(j)|$ der Elemente $h_k$ der Kanalschätzvektoren H(i) und H(j) erfolgt.

Die Frequenzablage des empfangenen Signals ist proportional zum Winkelargument arg[C(i)] der Maßzahl C(i). Der Proportionalitätsfaktor zwischen der Frequenzablage df und dem Winkelargument arg[C(i)] der Maßzahl C(i) ist von der zeitlichen Differenz zwischen den Meßzeitpunkten t(i), t(j), an denen die zur Berechnung der Maßzahl C(i) erforderlichen Schätzungen H(i) und H(j) der Kanalimpulsantworten vorgenommen werden, abhängig. Sofern der Zeitabstand zwischen zwei zur Ermittlung der Frequenzablage herangezogenen Kanalschätzungen jeweils gleich gewählt ist, ist der Proportionalitätsfaktor konstant.

Die exakte Beziehung zur Berechnung der Frequenzablage df lautet:

$$(2) \qquad df(i) = \frac{1}{2\pi \cdot [t(i)\text{-}t(j)]} \cdot arg[C(i)]$$

Eine näherungsweise Berechnung des Winkelarguments, sofern arg[C(i)] betragsmäßig kleiner ist als $\pi/2$, kann auch durch

$$(3) \qquad arg[C(i)] = \frac{\text{Imaginärteil } [C(i)]}{\text{Realteil } [C(i)]}$$

erfolgen. Dies ermöglicht eine einfache und schnelle und in den meisten Fällen ausreichende Abschätzung der Frequenzablage. Gerade die Berechnung triogonometrischer Funktionen ist immer mit Rechenaufwand verbunden, während im Fall dieser Näherung nur eine Division erforderlich ist.

Um zu statistisch aussagekräftigen Schätzungen der Frequenzablage zu gelangen, ist es von Vorteil, einen Mittelwert über mehrere Berechnungen der Frequenzablage zu bilden. Dies gilt insbesondere für schwundbehaftete Funkkanäle, bei denen einelne Schätzungen sehr unzuverlässig sein können. Von besonderem Vorteil ist es,einen komplexen Mittelwert C aus jeweils einer bestimmten Anzahl von aufeinanderfolgenden komplexen Maßzahlen C(i) zu bilden. In besonders einfacher Weise können hierzu jeweils die Realteile getrennt von den Imaginärteilen der komplexen Maßzahlen addiert werden. Die Frequenzablage df ergibt sich dann gemäß (2) oder (3) aus der gemittelten komplexen Maßzahl C. Diese Art der Mittelung ist möglich, da die Größe der Frequenzablage aus dem Winkelargument oder aus dem Verhältnis von Imaginärteil zu Realteil der komplexen Maßzahl erhalten wird und nicht von der absoluten Größe der Maßzahl abhängt. Aus diesem Grund ist es auch nicht erforderlich, die bei dieser Art der Mittelung erhaltene Summe durch die Anzahl der zu mittelnden Maßzahlen zu teilen. Dies bietet wiederum einen kleinen Vorteil in Bezug auf den Berechnungsaufwand.

Auf der anderen Seite ist der Betrag der Maßzahl C, ein Maß für die Zuverlässigkeit der Frequenzablagenschätzung, da die absoluten Werte der Elemente der Kanalschätzvektoren H(i) bzw. H(j) ein Maß für die Energie der Kanalimpulsantwort sind. Durch die komplexe Addition der Maßzahlen C(i) wird auf diese Weise zugleich eine Gewichtung in Bezug auf die Zuverlässigkeit der Frequenzablagenschätzung vorgenommen. Da die Störleistung für kurze Zeitabschnitte (die Zeitdauer eines "kurzen" Zeitabschnittes ist u.a. abhängig von der Frequenz und der Relativgeschwindigkeit zwischen Sender und Empfänger. Bei einem Zeitschlitz-Mobilfunksystem liegt ein kleiner Zeitabschnitt in der Größenordnung mehrerer weniger Zeitschlitze) in guter Näherung als konstant angenommen werden kann, sind Eingangssignale mit niedriger Energie der Kanalimpulsantwort gleichzeitig mit einem niedrigeren Signal-Rausch-Verhältnis verbunden, während Empfangssignale mit höherer Energie der Kanalimpulsantwort demgegenüber ein höheres Signal-Rausch-Verhältnis aufweisen. Die aus Empfangssignalen mit niedrigem Nutzsignal/RauschsignalVerhältnis gewonnenen Schätzwerte der Frequenzablage sind statistisch gesehen unsicherer als Schätzwerte, die aus einem Signal mit sehr großem Nutzsignal/Rauschsignal-Verhältnis gewonnen werden. Bei der vorgenannten Art der Mittelung werden auf aufwandsgünstige Weise die betrachteten Schätzwerte der Frequenzablage entsprechend ihrer statistischen Sicherheit gewichtet. Dies führt insbesondere bei schwundbehafteten Mehrwege-Funkkanälen zu einer deutlich zuverlässigeren Frequenzablagenschätzung, da einzelne, durch tiefe Schwundeinbrüche beeinträchtigte, Maßzahlen bei dieser Mittelung stark unterdrückt werden.

In einer weiteren Ausführungsform werden durch einen Störleistungsschätzer jeweils zu den Zeiten der Kanalvektorbildung Schätzwerte für die momentane Störleistung im Empfangssignal ermittelt und aufeinanderfolgend berechnete Maßzahlen vor einer Mittelung mit dem Kehrwert des geschätzten Störleistungswertes gewichtet. Gegenüber der vorstehend beschriebenen Weise der Mittelung bildet diese Art der Mittelung mit nach Störleistungswerten gewichteten Maßzahlen besonders dann Vorteile, wenn eine Mittelung über längere Zeitabschnitte vorgenommen wird und die Störleistung in diesem Zeitabschnitt nicht mehr als konstant angesehen werden kann.

In einer besonderen Ausführungsform kann es von Vorteil sein, beide Arten der Mittelwertbildung der Maßzahlen zu kombinieren. Eine solche Kombination ist besonders vorteilhaft bei Zeitschlitzübertragungsverfahren, in denen Informationen blockweise mit größeren zeitlichen Abständen zwischen den einzelnen Blöcken übertragen werden. In einem solchen Anwendungsfall ist es von Vorteil, die während eines Informationsblockes gebildeten Maßzahlen additiv zu einer einzigen Maßzahl zusammenzufassen. Anschließend werden die zusammengefaßten Maßzahlen der einzelnen Informationsblöcke mit einer für jeden Informationsblock ermittelten Störleistung gewichtet und aus diesen gewichteten Maßzahlen mehrerer aufeinanderfolgender Blöcke der Mittelwert gebildet. Dies hat den Vorteil, daß zur Gewichtung nur jeweils eine, für den gesamten Informationsblock geltende Störleistung ermittelt werden muß und dennoch von Block zu Block eine zuverlässige Gewichtung mit der Störleistung möglich ist.

Die auf vorstehende Weise gewonnenen Schätzwerte für die Frequenzablage eignen sich im besonderen Maße zur Regelung der an der Basisbandumsetzung verwendeten Oszillatoren, um die Frequenzablage durch entsprechende Nachführung der Oszillatoren auszuregeln.

Eine weitere vorteilhafte Ausgestaltung ist die Verwendung der Schätzwerte in einer Einrichtung zur Korrektur der Frequenzablage. Diese Einrichtung zur Frequenzkorrektur wird zwischen der Analog-Digital-Umsetzung und den Kanalschätzer bzw. vor einer vorgesehenen Basisbandsignalverarbeitung geschaltet und multipliziert das komplexe, nach der Basisbandumsetzung durch Abtastung und AD-Umsetzung erhaltene, Signal I + jQ mit einem geeignet abgetasteten und digitalisierten Abbild eines aus der Frequenzablage df gewonnenen Korrektursignals g = exp(j2$\pi$·df(i)·t). Bei Verwendung einer Einrichtung zur Korrektur der Frequenzlage brauchen die Oszillatoren nicht nachgeführt werden. Dies bietet insbesondere dann Vorteile, wenn ein Empfänger wechselweise auf verschiedenen Empfangsfrequenzen Signale empfängt.

In einem solchen Fall kann die Frequenzablage getrennt für jede Empfangsfrequenz ermittelt und gespeichert werden. Die bei einer Nachregelung der Oszillatoren ansonsten unvermeidlichen Einschwingzeiten entfallen bei einer solchen Lösung vollständig.

Im folgenden wird die Erfindung anhand eines in der Zeichnung dargestellen Ausführungsbeispiels näher beschrieben und erläutert.

Es zeigen:

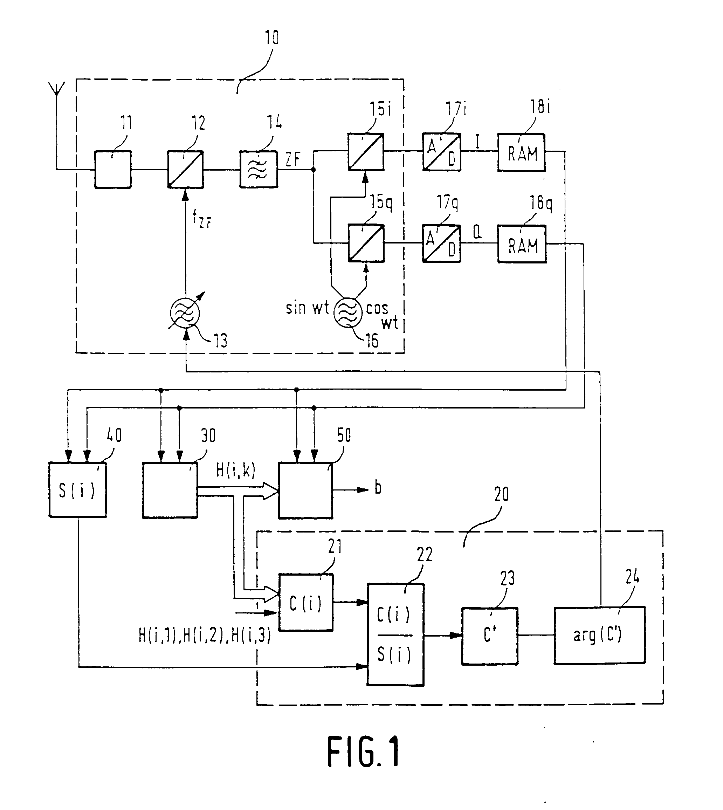

Fig. 1    eine schematische Schaltungsanordnung eines Funkempfängers mit einer Anordnung zur Frequenzablagenschätzung und einer Nachführung der Oszillatorfrequenz.

Fig. 2    eine schematische Darstellung eines Zeitschlitzes mit Trainingssignal.

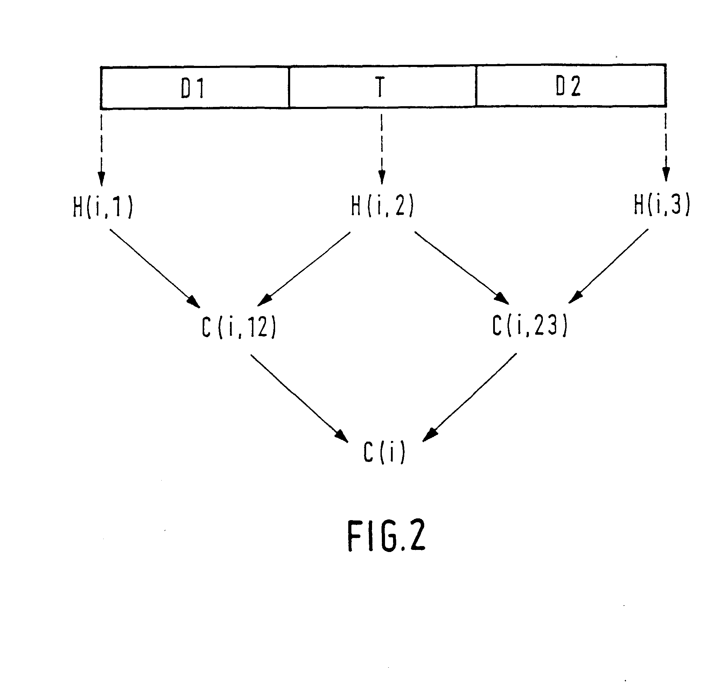

Im Ausführungsbeispiel ist ein Empfänger für ein Mobilfunksystem beschrieben, bei dem in blockweise übertragenen Daten jeweils eine Trainingsdatenfolge T bekannten Dateninhalts zwischen einer ersten Datenfolge D1 und einer zweiten Datenfolge D2 eingeschlossen ist (siehe Fig. 2).

Im HF-Teil 10 dieses Empfängers wird ein empfangenes Signal frequenzselektiert und auf eine Zwischenfrequenz umgesetzt. Hierzu wird das von einer HF-Empfangsstufe 11 empfangene Signal mittels eines ZF-Mischers 12, welchem von einem ZF-Oszillator 13 eine variable ZF-Mischfrequenz $f_{ZF}$ zugeführt ist, auf eine Zwischenfrequenz ZF heruntergemischt. Das auf diese erste Zwischenfrequenz heruntergemischte Eingangssignal wird in einem ZF-Verstärker 14 bandpaßgefiltert und verstärkt.

Im einem Basisbandumsetzer 15 wird das Zwischenfrequenzsignal ZF mit dem Ausgangssignal eines Basisbandoszillators 16 gemischt, wodurch der Signalinhalt des Zwischenfrequenzsignals ins Basisband umgesetzt wird. Im Ausführungsbeispiel erzeugt der Basisbandoszillator zwei Ausgangssignale gleicher Frequenz, die sich jedoch um 90° in der Phase unterscheiden und jeweils einem eigenen Mischer 15i, 15q zugeführt sind. Auf diese Weise werden die sogenannten Quadraturkomponenten I, Q des Empfangssignals gebildet. Durch Abtastung dieser beiden Quadraturkomponenten und Umsetzung der zu den Abtastzeitpunkten erhaltenen Abtastwerte in digitale Werte mittels eines Analog/Digital-Umsetzers 17i, 17q erhält man als Abtastwert z jeweils ein Wertepaar der Normalkomponente I und der Quadraturkomponente Q, welches jeweils blockweise in Speichern 18i, 18q zwischengespeichert wird.

Die Quadraturkomponenten I, Q sind sowohl einem adaptiven Kanalschätzer 30, einem Störleistungsschätzer 40 als auch einem Entzerrer/Detektierer 50 zugeführt. Aus der in der Datenfolge enthaltenen Trainingsdatenfolge T schätzt der Kanalschätzer 30 für jeden übertragenen Datenblock die zur Zeit der Übertragung vermuteten Kanalimpulsantworten des Übertragungskanals. Mittels der vom Kanalschätzer 30 geschätzten Kanalimpulsantworten nimmt der Entzerrer/ Detektierer 50 eine Entzerrung der Quadraturkomponenten und eine Detektion der ursprünglich gesendeten Datenfolge b vor.

Der Aufbau eines solchen Kanalschätzers 30 und eines solchen Entzerrers/Demodulators 50 ist dem Fachmann geläufig und ist beispielsweise auch in dem Aufsatz von A. Baier, "Correlative and iterative channel estimation in adaptive Viterbi equalizers for TDMA mobile radio systems", ITG-Fachbericht 107 zur Fachtagung "Stochastische Modelle und Methoden in der Informationstechnik", April 1989 beschrieben. Dort finden sich auch weitergehende Literaturhinweise.

Der dort geschilderte Kanalschätzer ist so ausgestaltet, daß er jeweils für die Mitte eines Datenblocks, in der sich die Trainingsdatenfolge T befindet, einen Anfangsschätzwert H(i,2) für die Kanalimpulsantwort bildet und den Schätzwert der Kanalimpulsantwort unter Berücksichtigung der detektierten Datenelemente innerhalb der Datenblocks entsprechend nachführt. Aus dieser nachgeführten Kanalimpulsantwort erhält man auf diese Weise jeweils eine Kanalimpulsantwort H(i,1) zu Beginn des Datenblocks D1 und eine Kanalimpulsantwort H(i,3) für das Ende des Datenblocks D2. Diese drei Kanalimpulsantworten eines Datenblocks werden dem Frequenzablagenschätzer 20 zugeführt.

Der Frequenzablagenschätzer 20 berechnet jeweils aus zwei zugeführten Kanalschätzvektoren einer Kanalimpulsantwort die Maßzahl C. Zur Bildung einer ersten Maßzahl C(i,12) werden alle Elemente des zweiten Kanalschätzvektors H(i,2) in ihren entsprechenden konjugiert komplexen Zahlenwert H(i,2)* überführt und die Summe aus den Produkten sich entsprechender Elemente mit dem ersten nachgeführten Kanalschätzvektor H(i,1) gebildet. Ebenso wird eine zweite Maßzahl C(i,23) aus dem konjugierten Wert der dritten, ebenfalls nachgeführten Kanalimpulsantwort H(i,3)* und der zweiten Kanalimpulsantwort H(i,2) gebildet. Aus diesen beiden Maßzahlen C(i,12) und C(i,23) wird durch Addition eine mittlere Maßzahl C(i) für den zum Zeitraum i empfangenen Datenblock ermittelt.

In einem Störleistungsmesser 40 wird für jeden Datenblock die während dieses Datenblocks aufgetretene Störleistung S(i) ermittelt. Diese Störleistung kann beispielsweise aus einer Messung der Rauschleistung ermittelt werden.

In einem Gewichtungsmodul 22 wird die für jeden Datenblock gemittelte Maßzahl C(i) mit der für diesen Datenblock geschätzten Störleistung S(i) gewichtet, indem die Maßzahl C(i) durch die Störleistung S(i) dividiert wird. In einem Summierungsmodul 23 werden die gewichteten Maßzahlen C(i)/S(i) einer bestimmten Anzahl n zurückliegender Datenblöcke gespeichert und summiert, um daraus einen Mittelwert C'(m) der gespeicherten Maßzahlen C(i)...C(i-n+1) zu ermitteln. Die Anzahl n der jeweils zu speichernden Maßzahlen C(i)...C(i-n+1) ist im Ausführungsbeispiel so gewählt, daß sie in etwa der Anzahl der Datenblöcke entspricht, die in einer Sekunde übertragen werden.

Aus der gemittelten Maßzahl C' wird schließlich in einem Phasendiskriminator 24 die Frequenzablage df ermittelt. Hierzu wird der Imaginärteil der gemittelten Maßzahl C' durch den Realteil der gemittelten Maßzahl C' dividiert. Nach Multiplikation mit einem Proportionalfaktor wird das Ausgangssignal des Phasendiskriminators 24 einem Steuereingang des ZF-Oszillators 13 zugeführt. Durch dieses Steuersignal wird der ZF-Oszillator 13 den Frequenzabweichungen des Eingangssignals nachgeführt.

**Patentansprüche**

1. Empfänger für mittels einer Trägerfrequenz übertragene Signale mit einer Basisbandumsetzung und einer Anordnung zur Schätzung einer Frequenzablage (Frequenzablagenschätzer),
   <u>dadurch gekennzeichnet,</u>
   daß das ins Basisband umgesetzte Signal einem Kanalschätzer (30) zugeführt ist, der Kanalschätzvektoren (H) als Schätzung der momentanen Kanalimpulsantworten in komplexer Basisbanddarstellung bildet, und daß der Frequenzablagenschätzer (20) die zeitlichen Veränderungen dieser Kanalschätzvektoren (H) auswertet.

2. Empfänger nach Anspruch 1,
   <u>dadurch gekennzeichnet,</u>
   daß der Frequenzablagenschätzer (20) aus jeweils zwei zu verschiedenen Zeitpunkten vorgenommenen Kanalschätzungen (H(i), H(j)) durch Aufsummation von Produkten sich entsprechender Elemente des einen Kanalvektors (H(i)) und konjungiert komplexer Elemente des anderen Kanalvektors (H(j)*) eine Maßzahl (C(i)) bildet, aus der sich die Frequenzablage ergibt.

3. Empfänger nach Anspruch 4,
   <u>dadurch gekennzeichnet,</u>
   daß aus einer vorgebbaren Anzahl aufeinanderfolgender Maßzahlen (C(i)) eine mittlere Maßzahl (C) bestimmt wird.

4. Empfänger nach einem der Ansprüche 2 oder 3,
   <u>dadurch gekennzeichnet,</u>
   daß ein Störleistungsschätzer (40) vorgesehen ist, mit dessen Störleistungsschätzwerten (S(i)) die Maßzahlen (C(i)) gewichtet und anschließend gemittelt werden.

5. Empfänger nach einem der Ansprüche 2, 3 oder 4,
   <u>dadurch gekennzeichnet,</u>
   daß ein Zahlenwert für die Frequenzablage durch Division des Winkelargumentes (arg(C(i)) durch das Produkt aus einer Konstanten und der zeitlichen Differenz (t(i)-t(j)) der beiden Kanalvektoren (H(i), H(j)) bestimmt wird.

6. Empfänger nach Anspruch 5,
   <u>dadurch gekennzeichnet,</u>
   daß als Näherung für das Winkelargument (arg(C(i)) das Verhältnis des Imaginärteils der Maßzahl (C(i)) zu dem Realteil der Maßzahl (C(i)) gewählt wird.

**7.** Empfänger nach einem der Ansprüche 1 bis 6,
dadurch gekennzeichnet,
daß die von dem Frequenzablagenschätzer (20) gebildeten Schätzwerte zur Frequenzregelung eines Oszillators (13) herangezogen werden.

**8.** Empfänger nach einem der Ansprüche 1 bis 6,
dadurch gekennzeichnet,
daß die vom Frequenzablagenschätzer (20) gebildeten Schätzwerte der Frequenzablage als Steuergröße für eine Einrichtung zur Korrektur einer Frequenzablage verwendet werden.

**9.** Sende-Empfangseinrichtung mit einem Empfänger nach einem der Ansprüche 1 bis 8.

**10.** Mobilfunkübertragungssystem mit einem Empfänger nach einem der Ansprüche 1 bis 8.

**Claims**

**1.** Receiver for signals transmitted with a carrier frequency, comprising a baseband conversion and an arrangement for estimating a frequency offset, characterized in that the signal converted to the baseband frequency is applied to a channel estimator (30) which forms channel estimation vectors (H) as estimates of the instantaneous channel impulse responses in a complex baseband representation, and in that the arrangement (20) for estimating a frequency offset evaluates the changes in time of these channel estimator vectors (H).

**2.** Receiver as claimed in Claim 1, characterized in that the arrangement (20) for estimating a frequency offset forms a coefficient (C(i)) from each two channel estimates (H(i), H(j)) made at different instants by a summation of the products of elements of one channel vector (H(i)) and conjugate complex elements of the other channel vector (H(j)*), from which coefficient the frequency offset is derived.

**3.** Receiver as claimed in Claim 2, characterized in that a mean coefficient (C) is determined from a predeterminable number of successive coefficients (C(i)).

**4.** Receiver as claimed in one of the Claims 2 or 3, characterized in that an interference power estimator (40) is provided, with whose interference power estimates (S(i)) the coefficients (C(i)) are weighted and then averaged.

**5.** Receiver as claimed in one of the Claims 2, 3 or 4, characterized in that a numerical value for the frequency offset is determined by means of a division of the angle argument (argC(i)) by the product of a constant and the time difference (t(i) - t(j)) of the two channel vectors (H(i), H(j)).

**6.** Receiver as claimed in Claim 5, characterized in that the proportion of the imaginary part of the coefficient (C(i)) to the real part of the coefficient (C(i)) is selected as an estimate for the angle argument (argC(i)).

**7.** Receiver as claimed in one of the Claims 1 to 6, characterized in that the estimates formed by the arrangement (20) for estimating a frequency offset are used for the frequency control of an oscillator (13).

**8.** Receiver as claimed in one of the Claims 1 to 6, characterized in that the estimates of the frequency offset formed by the arrangement (20) for estimating a frequency offset are used as control magnitudes for an arrangement for correcting a frequency offset.

**9.** Transceiving arrangement comprising a receiver as claimed in one of the Claims 1 to 8.

**10.** Mobile radio transmission system comprising a receiver as claimed in one of the Claims 1 to 8.

**Revendications**

**1.** Récepteur pour signaux transmis à l'aide d'une fréquence porteuse avec une conversion de bande de base et un circuit (20) d'évaluation d'un écart de fréquence, caractérisé en ce que le signal converti dans la bande de base est amené à un dispositif d'évaluation de canal (30) qui forme des vecteurs d'évaluation de canal (H) en évaluation des réponses instantanées d'impulsion de canal dans une représentation de bande de base complexe, et en ce que le circuit (20) d'évaluation d'un écart de fréquence interprète les variations temporelles de ces vecteurs d'évaluation de canal (H).

2. Récepteur selon la revendication 1, caractérisé en ce que le circuit (20) d'évaluation d'un écart de fréquence forme à partir de deux évaluations de canal [H(i), H(j)] effectuées à deux moments différents par addition de produits d'éléments correspondants de l'un des vecteurs de canal [H(i)] et d'éléments complexes conjugués de l'autre vecteur de canal [H(j)*] un indice [C(i))] qui permet de déterminer l'écart de fréquence.

3. Récepteur selon la revendication 2, caractérisé en ce qu'un indice moyen (C) est déterminé à partir d'un nombre prédéterminé d'indices [C(i)] successifs.

4. Récepteur selon l'une des revendications 2 ou 3 caractérisé en ce qu'il est prévu un dispositif d'évaluation des perturbations (40) dont les valeurs estimées des perturbations [S(i)] permettent de pondérer les indices [C(i)] et ensuite d'en établir une moyenne.

5. Récepteur selon l'une des revendications 2, 3 ou 4, caractérisé en ce qu'une valeur absolue pour l'écart de fréquence est déterminée par division de l'argument angulaire [arg{C(i)}] par le produit d'une constante et de la différence temporelle [t(i)-t(j)] des deux vecteurs de canal [H(i), H(j)].

6. Récepteur selon la revendication 5, caractérisé en ce que, comme approximation pour l'argument angulaire [arg{C(i)}], le rapport de la composante imaginaire de l'indice [C(i)] par rapport à la composante réelle de l'indice [C(i)] est choisi.

7. Récepteur selon l'une des revendications 1 à 6, caractérisé en ce que les valeurs estimées formées par le circuit (20) d'évaluation d'un écart de fréquence sont utilisées pour la régulation de fréquence d'un oscillateur (13).

8. Récepteur selon l'une des revendications 1 à 6, caractérisé en ce que les valeurs estimées formées par le circuit (20) d'évaluation d'un écart de fréquence sont utilisées comme grandeur de commande pour un dispositif de correction d'un écart de fréquence.

9. Dispositif émetteur/récepteur avec un récepteur selon l'une des revendications 1 à 8.

10. Système de transmission radio mobile avec un récepteur selon l'une des revendications 1 à 8.

FIG.1

| D 1 | T | D 2 |
|---|---|---|

H(i,1)          H(i,2)          H(i,3)

C(i,12)          C(i,23)

C(i)

# FIG.2